# DEMANDE DE BREVET EUROPEEN

(11) **EP 2 775 529 A2**
(43) Date de publication de la demande: **10.09.2014**
(21) Numéro de dépôt: 14157282.6
(22) Date de dépôt: 28.02.2014
(51) Int. Cl.: H01L 29/739, H01L 29/06, H01L 29/417

(54) **Transistor à effet tunnel**

(30) Priorité: 06.03.2013 FR 1352029
(71) Demandeur: COMMISSARIAT A L'ENERGIE ATOMIQUE ET AUX ENERGIES ALTERNATIVES, 75015 Paris (FR)
(72) Inventeur: Anghel, Costin, 92170 Vanves (FR); Le Royer, Cyrille, 38210 TULLINS-FURES (FR); Makosiej, Adam, 38000 Grenoble (FR)
(74) Mandataire: Lebkiri, Alexandre

(57) **Abrégé**

L'invention concerne un transistor (100) à effet tunnel comportant :
- un canal (101) réalisé dans un matériau semi-conducteur intrinsèque ;
- des régions d'extension de source (102) et de drain (103) de part et d'autre dudit canal (101), ladite région d'extension de source (102) étant réalisée dans un matériau semi-conducteur dopé selon un premier type de dopage P ou N et ladite région d'extension de drain (103) étant réalisée dans un matériau semi-conducteur dopé selon un second type de dopage inverse dudit premier type de dopage ;
- des régions conductrices de source (104) et de drain (105) respectivement en contact avec les régions d'extension de source (102) et de drain (103) ;
- une structure de grille (106) comportant une couche diélectrique (108) de grille en contact avec ledit canal et une zone de grille (107) agencée de sorte que ladite couche diélectrique de grille est disposée entre ladite zone de grille et ledit canal.

Ledit transistor comporte en outre une zone dopée selon le premier type de dopage (120) insérée entre le canal (101) et la région d'extension de drain (103).

## Description

La présente invention concerne le domaine de la microélectronique et a plus particulièrement pour objet un transistor à effet tunnel.

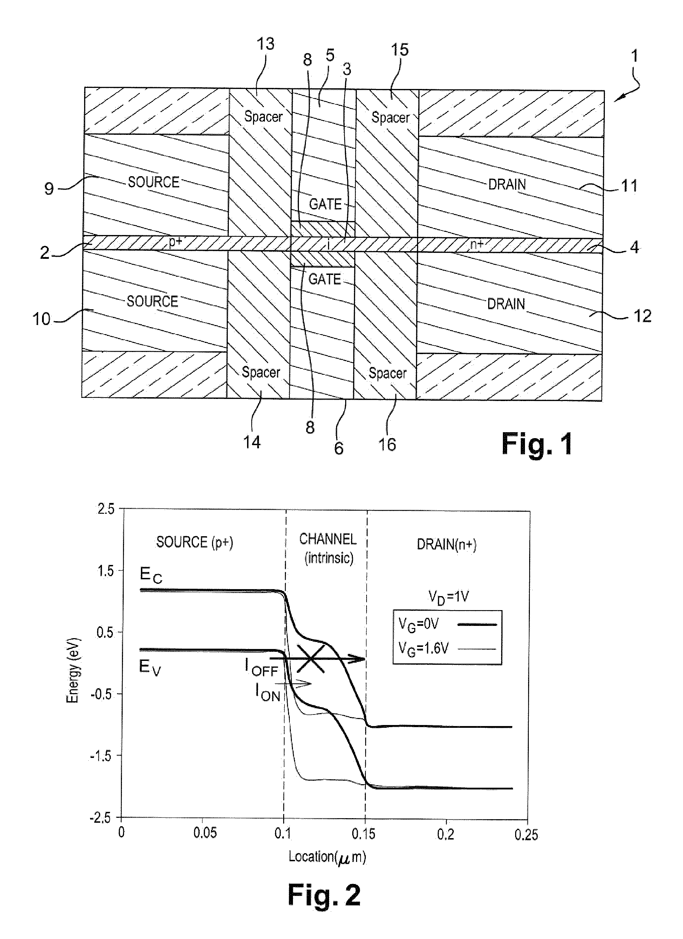

De manière générale, les transistors à effet tunnel TFET (« Tunnel Field Effect Transistor » en langue anglaise) sont de plus en plus envisagés pour remplacer les transistors de type CMOS, notamment pour des applications à faible puissance. Les transistors à effet tunnel (dit également à jonction tunnel) sont des diodes PiN à grille où le courant à l'état passant provient de porteurs passant de bande à bande par effet tunnel. Les transistors TFET présentent en effet des courants de fuite I_{off} (courant à l'état bloqué du transistor) très bas ainsi que des pentes sous seuil faibles (SS en mV/dec ou « Subthreshold Slope » en langue anglaise) comparés à des transistors CMOS de dimension similaire. Un exemple de structure d'un transistor TFET 1 de type N à double grille est illustré en figure 1. Le TFET 1 est basé sur une architecture de diode PiN avec une grille et comporte :
- une zone semi-conductrice 2 de source dopée p+ ;
- une zone semi-conductrice 3 de canal central intrinsèque ;
- une zone semi-conductrice 4 de drain dopée n+ ;
- deux zones de grille 5 et 6, par exemple métallique, au-dessus et au-dessous de la zone intrinsèque 3 et séparées de celle-ci par une couche diélectrique de grille (respectivement 7 et 8).

Le matériau diélectrique de la couche diélectrique de grille est le plus souvent un matériau à forte constante diélectrique, dit matériau « high-k » ; un tel matériau permet notamment d'obtenir de meilleurs courants de conduction.

On trouve de part et d'autre de la zone de source 2 des zones conductrices de source 9 et 10 (par exemple en NiSi) réalisées par exemple par siliciuration.

De même, on trouve de part et d'autre de la zone de drain 4 des zones conductrices de drain 11 et 12 (par exemple en NiSi) réalisées par exemple par siliciuration.

Les zones conductrices de source 9 et 10 sont respectivement isolées des zones de grille 5 et 6 (et de leur couche diélectrique associée) par des espaceurs 13 et 14.

Les zones conductrices de drain 11 et 12 sont respectivement isolées des zones de grille 5 et 6 (et de leur couche diélectrique associée) par des espaceurs 15 et 16.

La figure 2 illustre les diagrammes de bande du dispositif 1 en fonction de la position le long du dispositif 1 et selon les tensions appliquées à la grille, au drain et à la source.

Le principe de fonctionnement est le suivant : en appliquant une tension positive au niveau du drain (ici VD=1 V), on polarise la diode PiN en inverse créant ainsi une barrière de potentiel de sorte qu'on obtient un très faible courant I_{off} en mode bloqué. En appliquant une tension de grille positive (ici VG=1.6V), on augmente la probabilité de transition tunnel du côté de la source en rapprochant les bandes de valence et de conduction. Le transport est ensuite assuré par le champ électrique source/drain.

Comme mentionné plus haut, un des avantages du transistor TFET est qu'il offre un courant de fuite I_{off} très faible comparé à un transistor CMOS (et donc une puissance dissipée réduite en mode bloqué).

L'un des problèmes des transistors TFET réside toutefois dans leur performance en fonctionnement dynamique. Deux raisons expliquent les performances relativement faibles en fonctionnement dynamique.

Tout d'abord, les transistors TFET présentent une faible intensité de courant de conduction Iₒₙ (i.e. courant à l'état passant du transistor) comparée aux valeurs de Iₒₙ obtenues pour des transistors CMOS de dimension similaire.

En outre, les transistors TFET présentent des capacités parasites importantes, notamment la capacité grille-drain également appelée capacité de Miller : ces capacités parasites en augmentant diminuent la fréquence de fonctionnement en dynamique.

Dans ce contexte, la présente invention a pour but de fournir un transistor à effet tunnel présentant des caractéristiques améliorées en fonctionnement dynamique.

A cette fin, la présente invention a pour but de fournir un transistor à effet tunnel comportant :
- un canal réalisé dans un matériau semi-conducteur intrinsèque ;
- des régions d'extension de source et de drain de part et d'autre dudit canal, ladite région d'extension de source étant réalisée dans un matériau semi-conducteur dopé selon un premier type de dopage P ou N et ladite région d'extension de drain étant réalisée dans un matériau semi-conducteur dopé selon un second type de dopage inverse dudit premier type de dopage, ladite région d'extension de source servant à injecter par effet tunnel des porteurs de charge dans le canal ;
- des régions conductrices de source et de drain respectivement en contact avec les régions d'extension de source et de drain ;
- une structure de grille comportant :
   o une couche diélectrique de grille en contact avec ledit canal ;
   o une zone de grille agencée de sorte que ladite couche diélectrique de grille est disposée entre ladite zone de grille et ledit canal ;
ledit transistor étant caractérisé en ce qu'il comporte une zone dopée selon le premier type de dopage entre le canal et la région d'extension de drain, ladite zone dopée formant barrière, empêchant les porteurs de charges de s'échapper de ladite région d'extension de drain.

Comme nous le verrons par la suite, l'invention part du constat que les capacités parasites sont particulièrement gênantes pour de fortes tensions de grille (VG) accompagnées de faibles tensions de drain (VD).

Les capacités élevées à fort VG et faible VD viennent du fait que la tension élevée appliquée sur la grille génère à l'intérieur du transistor des états disponibles pour recevoir des électrons par effet tunnel. Ces états sont remplis par des électrons en provenance du drain. Ces états, à l'intérieur du transistor, constitue une charge totalement connectée avec le drain qui se comporte comme une capacité parasite de type Miller, connectée entre la grille et le drain. Les électrons sont attirés par la tension de grille et envahissent alors le canal.

Grâce à l'invention, la zone de dopage de type p+ (dans le cas d'une région d'extension de drain dopé n+) ou de type n+ (dans le cas d'une région d'extension de drain dopé p+) insérée entre le la région intrinsèque de canal et la région d'extension de drain permet de créer une barrière coté drain empêchant les électrons de s'échapper du drain et de pénétrer dans le canal à fort VG et faible VD.

Le transistor selon l'invention peut également présenter une ou plusieurs des caractéristiques ci-dessous, considérées individuellement ou selon toutes les combinaisons techniquement possibles :
- la concentration de dopants de ladite zone dopée selon le premier type de dopage est comprise entre 10¹⁹cm⁻³ et 5.10¹⁹cm⁻³ ;
- la concentration de dopants de ladite zone dopée selon le premier type de dopage est sensiblement égale à 3.10¹⁹cm⁻³ ;
- ladite zone dopée selon le premier type de dopage est insérée sur une longueur Lb donnée et mesurée selon la direction longitudinale du canal ;
- ladite longueur Lb est comprise entre 5 et 20nm ;
- ladite zone dopée selon le premier type de dopage est insérée sur une épaisseur donnée et mesurée perpendiculairement à au moins un plan de conduction dudit canal ;
- ladite épaisseur est comprise entre 8 et 20nm ;
- ledit canal comporte :
   o une première partie orientée selon la direction longitudinale du canal et présentant une épaisseur ts1 donnée et ;
   o et au moins une dérivation s'étendant suivant une direction perpendiculaire à au moins un plan de conduction dudit canal et présentant une épaisseur strictement supérieure à l'épaisseur ts1, ladite zone dopée selon le premier type de dopage étant dans le prolongement de ladite dérivation ;
- le transistor selon l'invention comporte un espaceur isolant la région conductrice de drain et la zone de grille, ledit espaceur présentant une épaisseur mesurée parallèlement à la direction longitudinale du canal comprise entre 5nm et 10nm ;
- les régions conductrices de drain et de source s'étendent respectivement au-dessus et/ou en-dessous des régions d'extension de source et de drain ;
- le canal présente au moins deux plans de conduction, ladite zone dopée selon le premier type de dopage étant insérée sur une épaisseur mesurée perpendiculairement à chacun des plans de conduction dudit canal.

D'autres caractéristiques et avantages de l'invention ressortiront clairement de la description qui en est donnée ci-dessous, à titre indicatif et nullement limitatif, en référence aux figures annexées, parmi lesquelles :
- la figure 1 illustre un exemple de structure d'un transistor TFET selon l'état de la technique ;
- la figure 2 représente le diagramme de bande du transistor de la figure 1 ;
- la figure 3 illustre schématiquement le découpage de l'espace VG-VD d'un transistor TFET ;
- la figure 4 représente schématiquement un inverseur TFET ;
- la figure 5 représente les réponses de l'entrée et de la sortie de l'inverseur TFET de la figure 4 ;
- la figure 6 représente la structure d'un transistor à effet tunnel selon l'invention ;
- les figures 7a à 7c représentent le diagramme de bande du transistor de la figure 6 pour plusieurs tensions de grille avec une tension de drain quasi nulle ;
- la figure 8 illustre l'évolution des capacités parasites en fonction de la tension de grille pour un transistor tel que celui de la figure 6 ;
- la figure 9 illustre l'évolution des capacités parasites en fonction de la tension de grille pour un transistor selon l'état de la technique tel que celui représenté en figure 1 ;
- la figure 10 représente schématiquement la structure d'un transistor à effet tunnel TFET à double grille selon un second mode de réalisation de l'invention ;
- la figure 11 représente schématiquement une variante du transistor de la figure 10 ;
- les figures 12a à 12f illustrent les étapes d'un mode de réalisation d'un procédé de fabrication d'un transistor selon l'invention ;
- les figures 13 et 14 représentent schématiquement la structure d'un transistor à effet tunnel TFET selon un troisième mode de réalisation de l'invention.

Dans toutes les figures, les éléments communs portent les mêmes numéros de référence. Pour des raisons de clarté, seuls les éléments utiles pour la compréhension de l'invention ont été représentés, et ceci sans respect de l'échelle et de manière schématique.

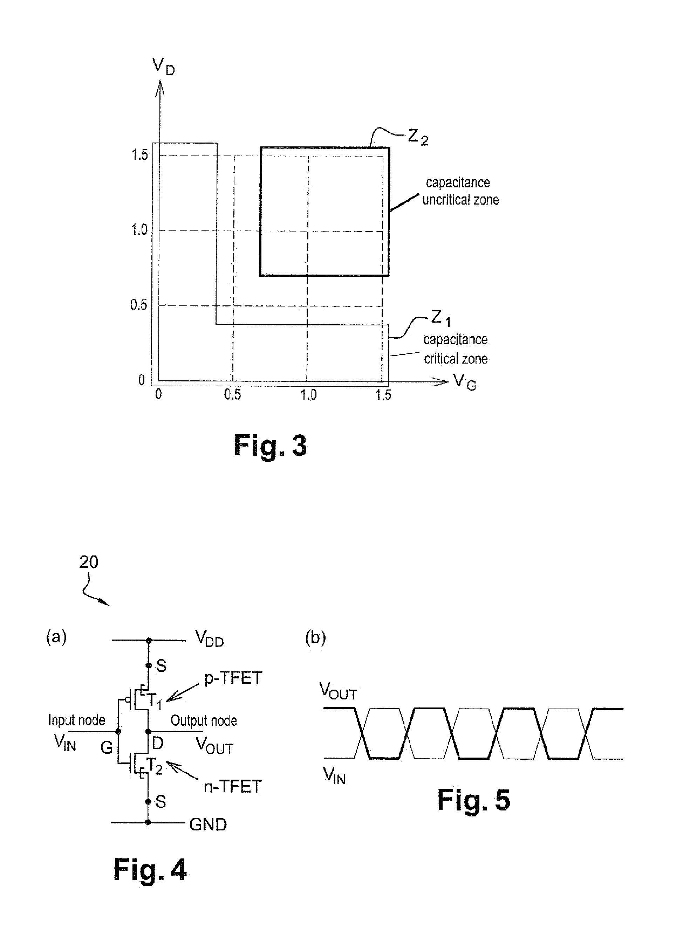

La figure 3 illustre schématiquement le découpage de l'espace de la tension de drain VD en fonction de la tension de grille VG d'un transistor TFET. Cette figure a pour but d'illustrer l'existence de deux zones :
- une première zone Z1 dans laquelle les valeurs de capacités sont très importantes et doivent être les plus faibles possibles pour avoir une commutation rapide (pour mémoire, l'augmentation de la valeur de la capacité parasite entraîne une diminution de la fréquence de fonctionnement en dynamique du transistor TFET) ;
- une seconde zone Z2 dans laquelle les valeurs des capacités parasites ne sont pas critiques pour la commutation.

La présence de ces deux zones Z1 et Z2 sera mieux comprise au regard des figures 4 et 5 qui représentent respectivement et schématiquement un inverseur TFET 20 et les réponses de l'entrée Vin et de la sortie Vout dudit inverseur TFET.

De façon connue, l'inverseur TFET 20 comporte un transistor à effet tunnel T1 de type P (p-TFET) et un transistor à effet tunnel T2 de type N (n-TFET) reliés par leur drain commun D, la source S du p-TFET T1 étant reliée à une tension d'alimentation VDD et la source S du n-TFET T2 étant reliée à la masse GND.

Le principe de fonctionnement logique de l'inverseur TFET 20 est le suivant : si l'entrée de l'inverseur change depuis un « 0 » logique vers un « 1 » logique, la sortie change depuis un « 1 » logique vers un « 0 » logique comme illustré en figure 5. A l'inverse, si l'entrée de l'inverseur change depuis un « 1 » logique vers un « 0 » logique, la sortie change depuis un « 0 » logique vers un « 1 » logique.

Donc, pour la commutation on peut avoir les deux situations suivantes :
Dans une première situation, VIN = 0 et VOUT = 1. Selon cette première situation, le p-TFET est polarisé à VSG = VS - VG = VDD et VSD = VS - VD = 0V et le n-TFET est polarisé à VGS = VG - VS = 0V et VDS = VD - VS = VDD.

Dans une seconde situation, VIN = 1 et VOUT = 0. Selon cette seconde situation, le p-TFET est polarisé à VSG = 0V et VSD = VDD et le n-TFET est polarisé à VGS = VDD et VDS = 0V.

Cette présentation des cas extrêmes démontre que lors de la commutation, les transistors p-TFET et n-TFET n'arrivent pas simultanément dans les conditions de polarisation à haut VG et VD. Ainsi, on comprend qu'il est intéressant de minimiser les capacités parasites dans la surface délimitée par la zone Z1 de la figure 3.

Les capacités parasites ont des valeurs relativement faibles pour VG faible et VD fort. Les valeurs faibles des capacités parasites à faible VG et fort VD s'expliquent par l'absence d'états disponibles pour recevoir des électrons par effet tunnel. En outre, la forte tension de drain VD entraîne une désertion complète des porteurs.

A l'inverse, les capacités parasites sont élevées à fort VG et faible VD. Comme évoqué plus haut, les capacités élevées à fort VG et faible VD viennent du fait que la tension élevée VG appliquée sur la grille génère à l'intérieur du transistor des états disponibles pour recevoir des électrons par effet tunnel. Ces états sont remplis par des électrons en provenance du drain. Ces états, à l'intérieur du transistor, constitue une charge totalement connectée avec le drain qui se comporte comme une capacité parasite de type Miller, connectée entre la grille et le drain. Les électrons sont attirés par la tension de grille et envahissent alors le canal.

Partant de ce dernier constat, l'invention vise à diminuer les capacités parasites dans la situation à fort VG et faible VD.

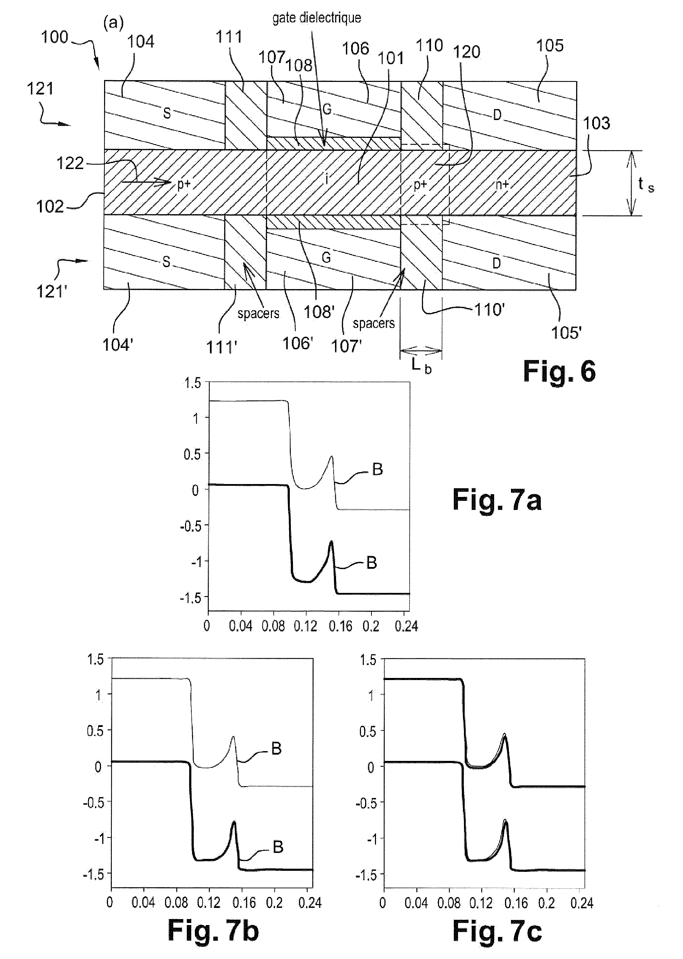

La figure 6 représente schématiquement la structure d'un transistor à effet tunnel TFET 100 à double grille selon l'invention.

Dans ce qui suit, l'association de la notation « ' » (prime) à une référence numérique d'un élément de la figure 6 indique qu'il s'agit d'un élément inférieur (i.e. au-dessous du canal prolongé de part et d'autre par les régions d'extension de drain et de source) symétrique d'un élément supérieur (i.e. au-dessus du canal prolongé de part et d'autre par les régions d'extension de drain et de source).

Le transistor à effet tunnel 100 est ici un transistor de type N comportant une architecture de diode PiN incluant :
- un canal central 101 réalisé dans un matériau semiconducteur (par exemple du silicium) intrinsèque ; on entend par semiconducteur intrinsèque un matériau semiconducteur dont le comportement électrique ne dépend que de sa structure, et non de l'adjonction d'impuretés dopantes ;
- une région d'extension de source 102 prolongeant le canal 101 à l'une de ses extrémités et réalisée dans un matériau semiconducteur fortement dopé P de type P+ (par exemple du Si dopé B) - cette région d'extension de source 102 servant à injecter par effet tunnel des porteurs de charge dans le canal ;
- une région d'extension de drain 103 prolongeant le canal 101 à l'autre de ses extrémités et réalisée dans un matériau semiconducteur fortement dopé N de type N+ (par exemple du Si dopé P) ;
- une zone de barrière 120 insérée entre le canal 101 et la région d'extension de drain 103, ladite zone de barrière 120 étant réalisée dans un matériau semiconducteur fortement dopé P de type P+ (par exemple du Si dopé B).

Dans tout le document, on entend par longueur la longueur mesurée selon la direction longitudinale du canal (repérée par la flèche 122) et par épaisseur une dimension mesurée selon une direction perpendiculaire au plan contenant le canal 101.

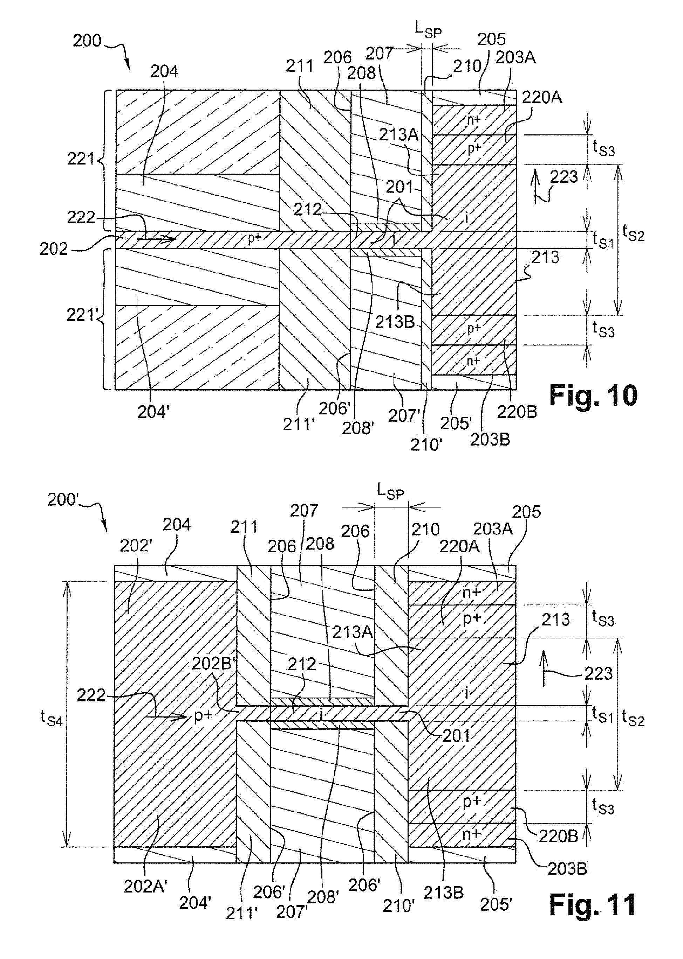

Selon ce premier mode de réalisation, la zone de barrière P+ 120 est insérée sur une longueur Lb selon la direction longitudinale du canal 101 entre ce dernier et la zone d'extension de drain 103. On notera que l'épaisseur t_{S} des régions d'extension de source 102, de drain 103 et du canal 101 est ici globalement constante ; cette dernière caractéristique n'est absolument pas limitative et on peut également avoir des régions d'extension de drain ou de source surélevées sans sortir du cadre de la présente invention (cf. par exemple la région d'extension de source 202' du mode de réalisation représentée en figure 11 qui sera décrit plus en détails par la suite).

Avantageusement, cette longueur Lb est comprise entre 5 et 20nm.

La concentration d'accepteurs (pour l'obtention d'un dopage de type P+) de la zone de barrière 120 est préférentiellement comprise entre 10¹⁹ cm⁻³ et 5.10¹⁹cm⁻³. A titre de comparaison, la concentration de dopants accepteurs dans la région d'extension de source 102 est comprise entre 10²⁰cm⁻³ et 5.10²⁰cm⁻³ (soit une concentration environ dix fois plus élevée que celle de la zone de barrière 120). Avantageusement, la concentration d'accepteurs (dopage de type P+) de la zone de barrière 120 est sensiblement égale à 3.10¹⁹cm⁻³. On notera que la concentration de donneurs (dopage de type N+) dans la région d'extension de drain 103 influe peu sur la valeur sur la concentration d'accepteurs de la zone de barrière 120. Une augmentation de la concentration de la zone p+ au-delà des valeurs mentionnées plus haut (par exemple à 7x10¹⁹ cm⁻³) induit une diminution de la tension d'alimentation (on observe sinon l'apparition des forts courants parasites dans l'état bloqué du transistor via un effet tunnel parasite non-contrôlé du côté du drain).

De façon connue, le transistor 100 comporte en outre :
- une partie supérieure 121 sous la forme d'une série d'éléments successifs situés au-dessus de l'ensemble formé par le canal 101 entouré des régions d'extension 102 et 103, dans le sens longitudinal (repéré par la flèche 122) du canal à partir de la région d'extension de source et intégrant :
   o une région conductrice de source 104 ;
   o des moyens 111 pour former un espace isolant de source entre les flancs en regard l'un de l'autre de la région conductrice de source 104 et de la structure de grille 106 qui suit ;
   o une structure de grille 106 comportant :
      ■ une couche diélectrique 108 de grille ; le matériau de la couche diélectrique 108 est préférentiellement un matériau diélectrique de type high-k tel que le HfO₂ ;
      ■ une zone conductrice de grille 107 au-dessus de la couche diélectrique de grille 108 et au-contact de celle-ci ; le matériau de la zone conductrice de grille 107 est par exemple un métal ;
   o des moyens 110 pour former un espace isolant de drain entre les flancs en regard l'un de l'autre de la structure de grille 106 et de la région conductrice de drain 105 qui suit ;
   o une région conductrice de drain 105 ;
- une partie inférieure 121' sous la forme d'une série d'éléments successifs situés au-dessous de l'ensemble formé par le canal 101 entouré des régions d'extension 102 et 103, dans le sens longitudinal du canal à partir de la région d'extension de source et intégrant :
   o une région conductrice de source 104' ;
   o des moyens 111' pour former un espace isolant de source entre les flancs en regard l'un de l'autre de la région conductrice de source 104' et de la structure de grille 106' qui suit ;
   o une structure de grille 106' comportant :
      ■ une couche diélectrique 108' de grille ; le matériau de la couche diélectrique 108' est préférentiellement un matériau diélectrique de type high-k tel que le HfO₂ ;
      ■ une zone conductrice de grille 107' au-dessus de la couche diélectrique de grille 108' et au-contact de celle-ci ; le matériau de la zone conductrice de grille 107' est par exemple un métal ;
   o des moyens 110' pour former un espace isolant de drain entre les flancs en regard l'un de l'autre de la structure de grille 106' et de la région conductrice de drain 105' qui suit ;
   o une région conductrice de drain 105'.

L'ensemble des moyens espaceurs est préférentiellement réalisé dans un matériau diélectrique low-k tel que du SiO₂ étant entendu que ces moyens ne sont pas nécessairement formés d'un seul matériau et/ou d'une seule couche. Les dimensions mesurées selon la direction longitudinale 122 du canal 101 des moyens espaceurs 110 et 110' sont par exemple de l'ordre de 15nm (comprise entre 5nm et 30 nm pour structure planaire).

La zone de barrière 120 de type p+ permet de créer une barrière coté drain empêchant les électrons de s'échapper du drain et de pénétrer dans le canal à fort VG et faible VD. Ce phénomène est notamment illustré aux figures 7a à 7b qui représentent respectivement le diagramme de bande du transistor 100 de la figure 6 pour deux tensions de grille différentes avec une tension de drain sensiblement nulle. La figure 7c représente la superposition des deux diagrammes des figures 7a et 7b.

Les figures 7a et 7b montrent qu'une barrière B a été créée sur la structure des bandes par le dopage de type p+ intercalé entre le canal (intrinsèque) et la région d'extension de drain (de type n+) et que cette barrière est présente quelle que soit la tension de grille. La figure 7c démontre par ailleurs que la barrière entre le canal et la région d'extension de drain est très faiblement influencée par la polarisation de la grille (la barrière B reste sensiblement la même quelle que soit la tension de grille). Cette barrière B créé par la zone de barrière 120 de la figure 6 empêche la pénétration des électrons de la région d'extension de drain 103 vers le canal 101.

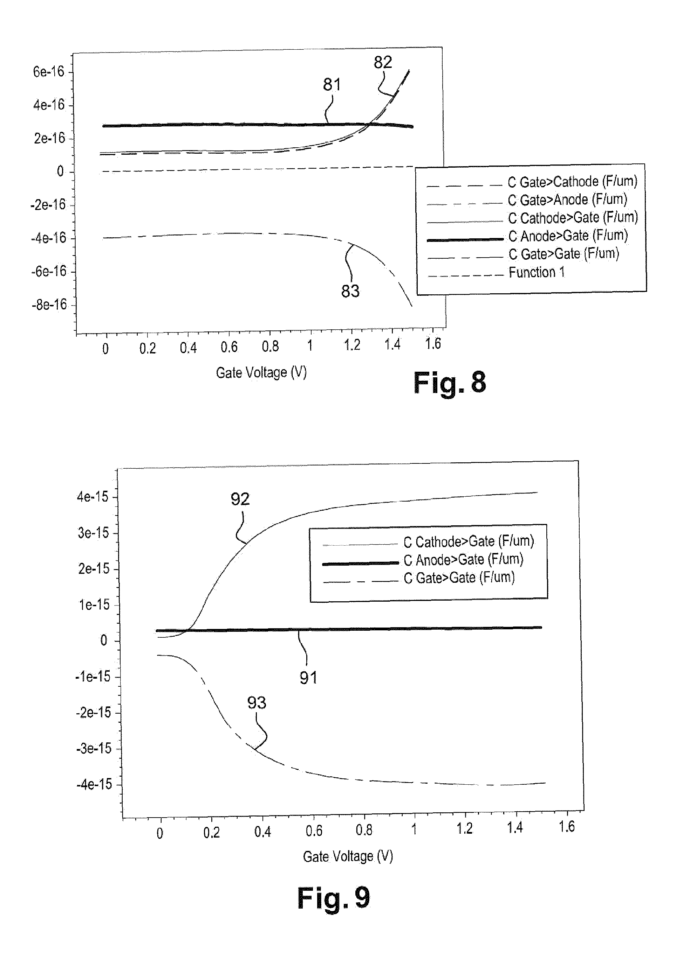

La figure 8 illustre l'évolution des capacités parasites (unité : F/µm) en fonction de la tension de grille (unité : V) pour un transistor selon l'invention tel que celui de la figure 6 :
- la courbe 81 représente l'évolution de la capacité parasite entre la région d'extension de source et la grille ;
- la courbe 82 représente l'évolution de la capacité parasite entre la grille et la région d'extension de drain ;
- la courbe 83 représente l'évolution de la capacité parasite totale.

La figure 9 illustre l'évolution des capacités parasites (unité : F/µm) en fonction de la tension de grille (unité : V) pour un transistor de l'état de la technique tel que le transistor de la figure 1 :
- la courbe 91 représente l'évolution de la capacité parasite entre la région d'extension de source et la grille ;
- la courbe 92 représente l'évolution de la capacité parasite entre la grille et la région d'extension de drain ;
- la courbe 93 représente l'évolution de la capacité parasite totale.

On notera que certaines capacités ont des valeurs négatives et d'autres des valeurs positives mais le signe de ces capacités n'a pas de signification : il convient donc de comparer les valeurs absolues de ces capacités.

Les courbes des figures 8 et 9 ont été obtenues pour une tension de drain sensiblement nulle.

La figure 8 démontre que les capacités parasites sont maintenues à des valeurs faibles sur une gamme très large de tension de grille (i.e. jusqu'à une tension de grille de 1 V). On constate par ailleurs que, avec une structure selon l'invention, la capacité parasite totale, c'est-à-dire la courbe 83 (qui correspond sensiblement à la somme des capacités entre la région d'extension de source et la grille et entre la grille et la région d'extension de drain), est dominée jusqu'à VG=1V par la capacité entre la région d'extension de source et la grille (courbe 81). En d'autres termes, grâce à l'invention, on réduit considérablement l'effet de la capacité entre la grille et la région d'extension de drain. Ce comportement est très proche de celui observé pour un transistor réalisé selon la technologie MOSFET.

A l'inverse, en analysant la figure 9, on observe que les capacités d'un transistor à effet tunnel selon l'état de la technique sont d'un ordre de grandeur plus élevé pour une tension de grille VG inférieure ou égale à 1 V (on passe d'une capacité de l'ordre de 4.10⁻¹⁶ F/µm pour l'invention à une capacité de l'ordre de 4.10⁻¹⁵ F/µm pour le transistor selon l'état de la technique). En outre, on constate que la capacité entre la grille et la région d'extension de drain (courbe 92) influe considérablement sur la capacité totale (93). La figure 9 montre des capacités élevées même à des tensions de grille faibles (cf. VG= 0.3V).

On notera que les courbes 81 et 91 représentant les capacités entre la région d'extension de source et la grille sont très proches : ce résultat est compréhensible dans la mesure où la zone de barrière selon l'invention ne vise pas à réduire cette capacité parasite.

La figure 10 représente schématiquement la structure d'un transistor à effet tunnel TFET 200 à double grille selon un second mode de réalisation de l'invention.

Le transistor 100 de la figure 6 possédait une structure planaire avec une épaisseur ts sensiblement constante sur la longueur de la région d'extension de source, du canal et de la région d'extension de drain. La zone de barrière était donc insérée selon la direction longitudinale du canal en conservant cette même épaisseur constante.

Le transistor 200 selon l'invention se différencie du transistor 100 en ce qu'il possède une structure verticale c'est-à-dire que l'ensemble formé par la région d'extension de drain, le canal et la région d'extension de source ne s'étend plus suivant la direction longitudinale du canal avec une épaisseur constante.

Dans ce qui suit, l'association de la notation « ' » (prime) à une référence numérique d'un élément de la figure 10 indique qu'il s'agit d'un élément inférieur (i.e. au-dessous du canal prolongé de part et d'autre par les régions d'extension de drain et de source) symétrique d'un élément supérieur (i.e. au-dessus du canal prolongé de part et d'autre par les régions d'extension de drain et de source).

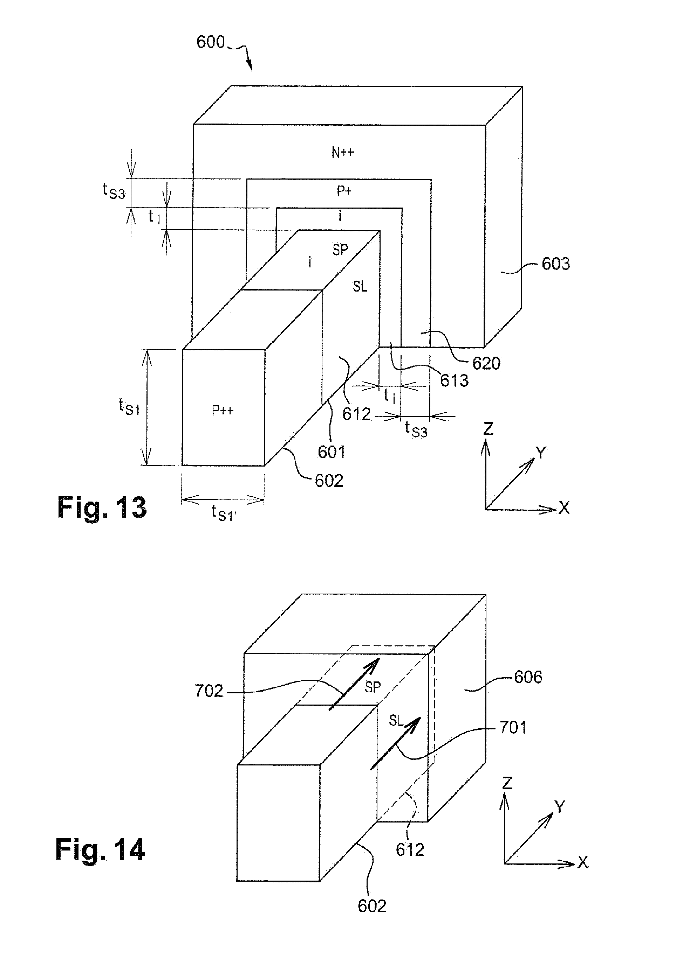

Dans tout le document, on entend par longueur la longueur mesurée selon la direction longitudinale du canal (repérée par la flèche 222) et par épaisseur une dimension mesurée selon une direction perpendiculaire (repérée par la flèche 223) au plan du canal (ici le plan horizontal perpendiculaire au plan de la feuille représentant le transistor 200). Nous verrons par la suite (cf. figure 13) qu'un transistor selon l'invention peut comporter plusieurs plans de conduction intégrant un canal de conduction.

Le transistor à effet tunnel 200 est ici un transistor de type N comportant une architecture de diode PiN incluant :
- un canal 201 réalisé dans un matériau semiconducteur (par exemple du silicium) intrinsèque ; on entend par semiconducteur intrinsèque un matériau semiconducteur dont le comportement électrique ne dépend que de sa structure, et non de l'adjonction d'impuretés dopantes ; ce canal 201 inclut deux parties d'épaisseurs différentes ; une première partie 212 d'épaisseur ts1 et une deuxième partie 213 d'épaisseur ts2 strictement supérieure à l'épaisseur ts1. Plus précisément, le transistor 200 étant un transistor à double grille, la seconde partie 213 est formée d'une première dérivation 213A s'étendant suivant la direction 223 dans un premier sens (ici le haut dans le cas de la figure 10) suivant une épaisseur ts2/2 strictement supérieure à ts1 et d'une seconde dérivation 213B s'étendant suivant la direction 223 dans le sens opposé au premier sens (ici le bas dans le cas de la figure 10) suivant une épaisseur ts2/2 strictement supérieure à ts1 ;
- une région d'extension de source 202 prolongeant, selon la direction longitudinale 222, la première partie 212 du canal 201 et réalisée dans un matériau semiconducteur fortement dopé P de type P+ (par exemple du Si dopé B) ; la région d'extension de source 202 présente une épaisseur ts1 sensiblement égale à l'épaisseur de la première partie 212 ;
- une première région d'extension de drain 203A prolongeant, selon la direction 223 perpendiculaire au plan du canal 201 la première dérivation 213A et réalisée dans un matériau semiconducteur fortement dopé N de type N+ (par exemple du Si dopé P) ;
- une deuxième région d'extension de drain 203B prolongeant, selon la direction 223 perpendiculaire au plan du canal 201 la deuxième dérivation 213B et réalisée dans un matériau semiconducteur fortement dopé N de type N+ (par exemple du Si dopé P) ;
- une première zone de barrière 220A insérée, selon la direction 223 sur une épaisseur ts3, entre la première dérivation 213A et la première région d'extension de drain 203A, ladite première zone de barrière 220A étant réalisée dans un matériau semiconducteur fortement dopé P de type P+ (par exemple du Si dopé B) ;
- une deuxième zone de barrière 220B insérée, selon la direction 223 sur une épaisseur ts3, entre la deuxième dérivation 213B et la deuxième région d'extension de drain 203B, ladite deuxième zone de barrière 220B étant réalisée dans un matériau semiconducteur fortement dopé P de type P+ (par exemple du Si dopé B).

Selon ce second mode de réalisation, les zones de barrière P+ 220A et 220B sont donc insérées sur une épaisseur ts3 selon la direction 223 perpendiculaire au plan du canal entre l'extrémité du canal 201 et la zone d'extension de drain 203.

Avantageusement, cette épaisseur ts3 de chacune des zones de barrière 220A et 220B est comprise entre 8 et 20nm.

La concentration d'accepteurs (pour l'obtention d'un dopage de type P+) de chacune des zones de barrière 220A et 220B est préférentiellement comprise entre 10¹⁹cm⁻³ et 5.10¹⁹cm⁻³. A titre de comparaison, la concentration de dopants accepteurs dans la région d'extension de source 202 est comprise entre 10²⁰cm⁻³ et 5.10²⁰cm⁻³ (soit une concentration environ dix fois plus élevée que celle des zones de barrière 220A et 220B). Avantageusement, la concentration de dopants (dopage de type P+) de chacun des zones de barrière 220A et 220B est sensiblement égale à 3.10¹⁹cm⁻³.

De façon connue, le transistor 200 comporte en outre :
- une partie supérieure 221 sous la forme d'une série d'éléments successifs situés au-dessus de l'ensemble formé par le canal 201 et les régions d'extension 202 et 203, dans le sens longitudinal (repéré par la flèche 222) du canal à partir de la région d'extension de source et intégrant :
   o une région conductrice de source 204 ;
   o des moyens 211 pour former un espace isolant de source entre les flancs en regard l'un de l'autre de la région conductrice de source 204 et de la structure de grille 206 qui suit ;
   o une structure de grille 206 comportant :
      ■ une couche diélectrique 208 de grille ; le matériau de la couche diélectrique 208 est préférentiellement un matériau diélectrique de type high-k tel que le HfO₂ ;
      ■ une zone conductrice de grille 207 au-dessus de la couche diélectrique de grille 208 et au-contact de celle-ci ; le matériau de la zone conductrice de grille 207 est par exemple un métal ;
   o des moyens 210 pour former un espace isolant de drain et de canal entre les flancs en regard l'un de l'autre de la structure de grille 206 et de la région conductrice de drain 205 qui suit ;
   o une région conductrice de drain 205 ;
- une partie inférieure 221' sous la forme d'une série d'éléments successifs situés au-dessous de l'ensemble formé par le canal 201 et les régions d'extension 202 et 203, dans le sens longitudinal (repéré par la flèche 222) du canal à partir de la région d'extension de source et intégrant :
   o une région conductrice de source 204' ;
   o des moyens 211' pour former un espace isolant de source entre les flancs en regard l'un de l'autre de la région conductrice de source 204' et de la structure de grille 206' qui suit ;
   o une structure de grille 206' comportant :
      ■ une couche diélectrique 208' de grille ; le matériau de la couche diélectrique 208' est préférentiellement un matériau diélectrique de type high-k tel que le HfO₂ ;
      ■ une zone conductrice de grille 207' au-dessus de la couche diélectrique de grille 208' et au-contact de celle-ci ; le matériau de la zone conductrice de grille 207' est par exemple un métal ;
   o des moyens 210' pour former un espace isolant de drain et de canal entre les flancs en regard l'un de l'autre de la structure de grille 206' et de la région conductrice de drain 205' qui suit ;
   o une région conductrice de drain 205'.

L'ensemble des moyens espaceurs est préférentiellement réalisé dans un matériau diélectrique low-k tel que du SiO₂, étant entendu que ces moyens ne sont pas nécessairement formés d'un seul matériau et/ou d'une seule couche. La dimension LSP mesurée selon la direction longitudinale 222 du canal 201 des moyens espaceurs 210 et 210' est de l'ordre de 5nm. Une structure verticale telle que celle de la figure 10 permet précisément d'utiliser des espaceurs de dimension plus réduite (ici 5nm versus 15nm dans le cas du transistor de la figure 6). Il convient par ailleurs de noter que, même pour des espaceurs de dimensions réduites du côté du drain, le courant ambipolaire reste toujours très faible.

Les zones de barrière 220A et 220B de type p+ permettent de créer une barrière coté drain empêchant les électrons de s'échapper du drain et de pénétrer dans le canal à fort VG et faible VD.

La figure 11 illustre un transistor à effet tunnel 200' qui est une variante de réalisation du transistor 200 de la figure 10.

Le transistor 200' est sensiblement identique au transistor 200 (les caractéristiques identiques présentent les mêmes références), la seule différence consistant à utiliser une région d'extension de source 202' surélevée (versus la région d'extension de source 202 de la figure 10) ; selon ce mode de réalisation, la région d'extension de source 202' inclut deux parties d'épaisseurs différentes ; une première partie 202A' d'épaisseur ts4 et une deuxième partie 202B' d'épaisseur ts1 strictement inférieure à l'épaisseur ts4 et sensiblement égale à l'épaisseur de la première partie 212 du canal 201.

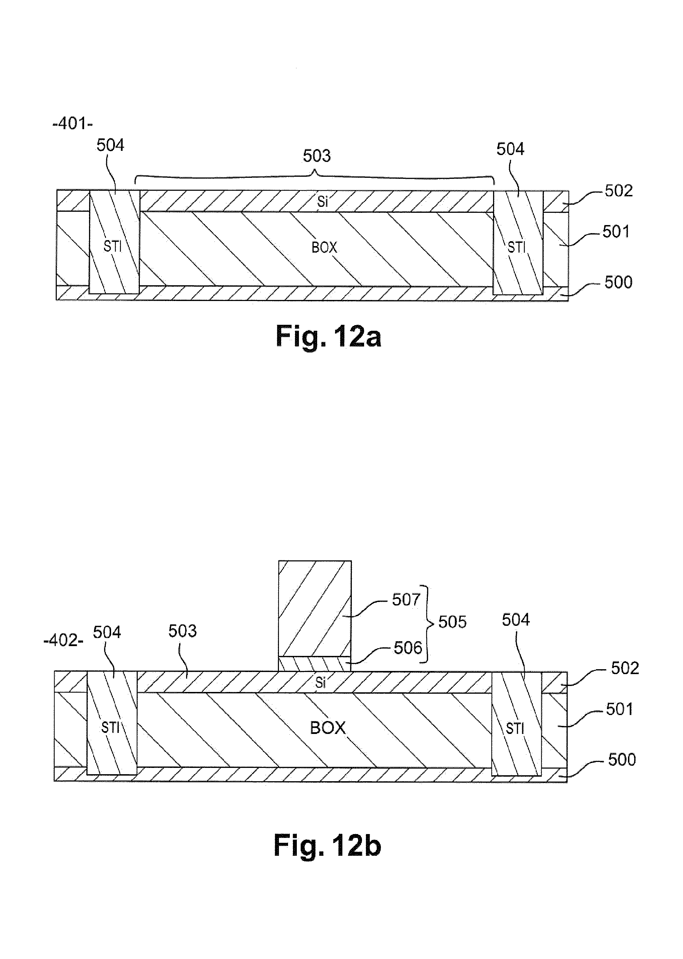

Les figures 12a à 12f illustrent les étapes d'un mode de réalisation d'un procédé de fabrication d'un transistor selon l'invention qui est ici un transistor simple grille. L'exemple est celui d'un transistor TFET de type N.

Selon la première étape 401 illustrée en figure 12a, on utilise un substrat du type semiconducteur sur isolant ou SOI (« Silicon On Insulator ») comprenant une première couche semiconductrice 500, par exemple à base de silicium sur laquelle repose une couche isolante 501 telle qu'une couche d'oxyde enterré (BOX ou « buried oxide » en anglais) à base de SiO₂ (le BOX peut être épais, par exemple sur une épaisseur de 145nm, ou préférentiellement mince pour le contrôle électrostatique, par exemple sur une épaisseur de 25nm, ou même 10nm). On a ensuite une fine couche semi-conductrice 502 (par exemple un film mince de silicium par exemple sur une épaisseur inférieure à 30 nm voire inférieure à 10nm pour une technologie SOI de type « fully depleted »).

Selon cette même étape 401, on va définir la zone active 503, par exemple par la réalisation de tranchées 504. Ces tranchées sont réalisées par un procédé d'isolation par tranchées (STI pour « Shallow Trench Isolation). En STI, une gravure localisée des tranchées dans le substrat SOI est réalisée. Cette étape est suivie d'un remplissage des tranchées 504 de silice.

La zone active 503 peut également être réalisée par une gravure MESA.

La seconde étape 402 illustrée en figure 12b consiste à réaliser la structure de grille 505. Pour ce faire, on dépose par exemple une couche de diélectrique high-k 506 tel que du HfO2 puis une couche métallique et/ou de polysilicium dopé 507. La zone de grille 505 est ensuite obtenue par lithographie et gravure (avec arrêt sur la couche 502 de silicium) des couches diélectrique et métal/polySi déposées précédemment. On notera qu'on peut également déposer un masque dur (par exemple en SiN) au-dessus de la zone de grille 505 pour ne pas avoir de Silicium apparent en haut de la zone de grille (et éviter un impact sur la surface de grille au moment des épitaxies de source et de drain à venir).

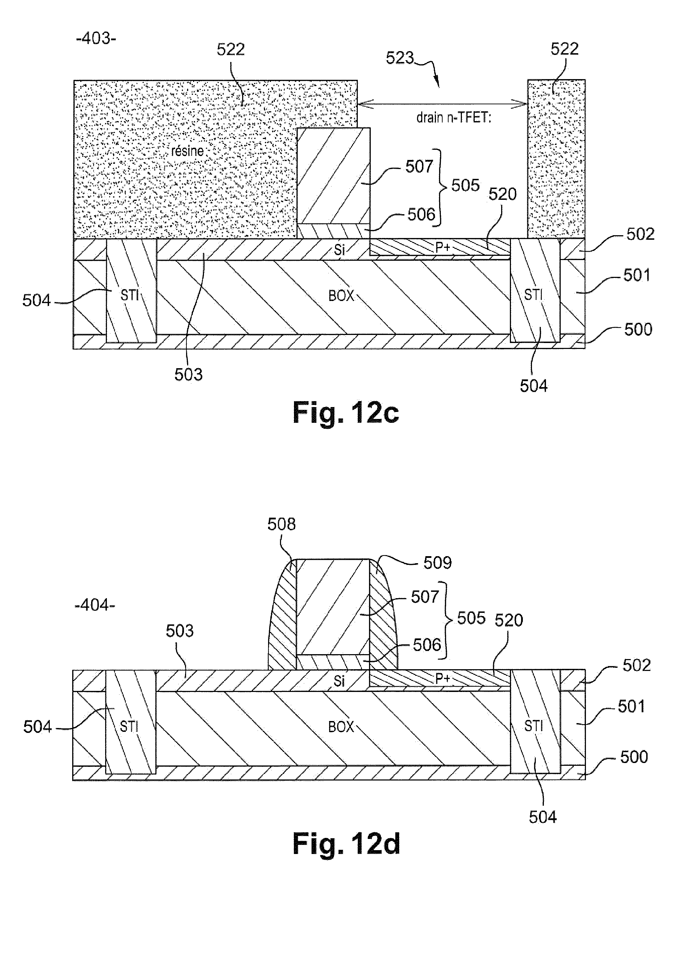

Selon l'étape 403 illustrée en figure 12c, on réalise le dopage P+ de la zone 520 destiné à incorporer la future zone de barrière et la future région d'extension de drain. Ce dopage est réalisé en définissant tout d'abord un caisson de résine 522 dans lequel on ouvre la zone à doper (l'ouverture 523 est obtenue par lithographie). La zone ouverte est dopée P+ par implantation ionique (par exemple une implantation par des ions B ou des ions BF2). Le caisson de résine est ensuite retiré par une méthode de type « stripping » ou « lift-off ».

Selon l'étape 404 illustrée en figure 12d, on définit les espaceurs 508 et 509 (côté source et drain équivalents aux espaceurs 111 et 110 de la figure 6). Cette réalisation est par exemple obtenue en faisant un dépôt conforme d'un matériau diélectrique de type low-k (tel que du SiO₂) sur une épaisseur typiquement inférieure à 20nm suivi d'une gravure anisotrope de type gravure sèche RIE (pour « Reactive Ion Etching »). Cette gravure anisotrope permet de définir la longueur des espaceurs 508 et 509 (calculée selon le sens longitudinal du canal) typiquement comprise entre 5 et 30 nm.

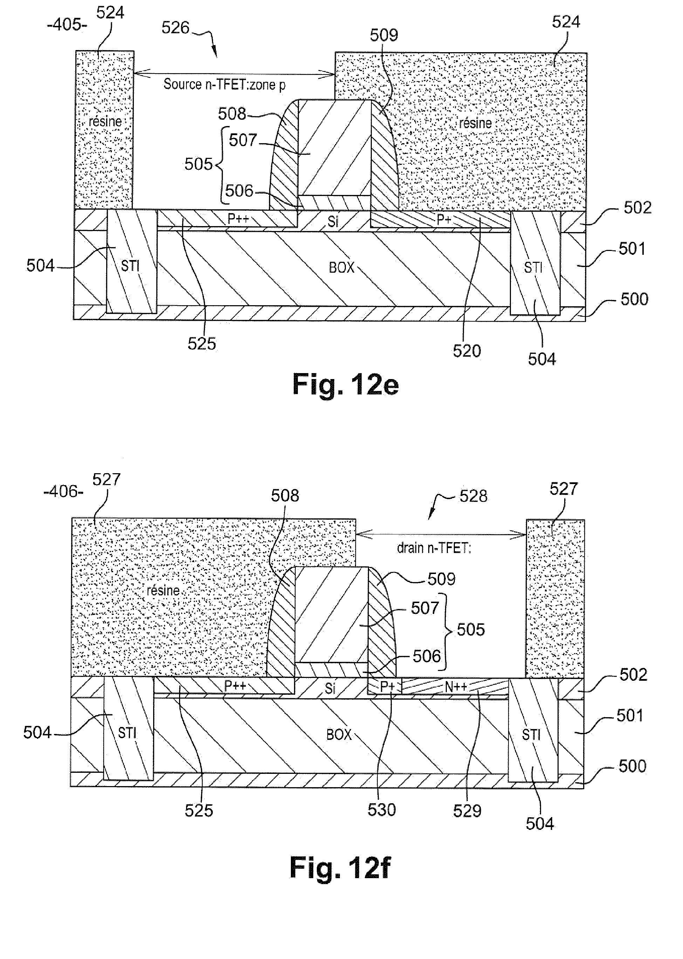

Selon l'étape 405 illustrée en figure 12e, on réalise le dopage P+ de la zone d'extension de source 525. Ce dopage est réalisé en définissant tout d'abord un caisson de résine 524 dans lequel on ouvre la zone à doper (l'ouverture 526 est obtenue par lithographie). La zone ouverte est dopée P+ par implantation ionique (par exemple une implantation par des ions B ou des ions BF2). Le caisson de résine est ensuite retiré par une méthode de type « stripping » ou « lift-off ».

Selon l'étape 406 illustrée en figure 12f, on va réaliser le dopage N+ de la zone d'extension de drain 529 (au niveau de la région 520) en laissant une zone 530 dopé P+ qui servira de zone de barrière. Ce dopage est réalisé en définissant tout d'abord un caisson de résine 527 dans lequel on ouvre la zone à doper (l'ouverture 528 est obtenue par lithographie). La zone ouverte est dopée N+ par implantation ionique (par exemple une implantation par des ions As ou P).

Selon l'étape suivante non représentée, on finalise le dispositif selon l'invention ; pour ce faire, le caisson de résine 527 est retiré par une méthode de type « stripping » ou « lift-off ». Afin d'activer les atomes dopants et de guérir les défauts dus au bombardement, on réalise ensuite un recuit d'implantation (dit également recuit d'activation).
La figure 13 représente schématiquement la structure d'un transistor 600 à effet tunnel TFET multi-grilles en trois dimensions (par exemple un transistor de type Fin-TFET ou « TFET Trigate ») selon un troisième mode de réalisation de l'invention. On notera que le dessin de la figure 13 a uniquement pour but d'illustrer très schématiquement la structure du transistor étant entendu que les formes réelles seront le plus souvent non rectangulaires mais trapézoïdales (lesdites formes étant liées aux procédés d'épitaxie utilisés pour la fabrication).

Les transistors 100, 200 ou 200' tels que décrit en référence aux figures 6, 10 et 11 possédaient chacun un canal de conduction contenu dans un seul plan, dit plan de conduction : ces structures sont des structures avec une seule surface de conduction. La structure du transistor 600 représenté schématiquement en figure 13 présente au contraire plusieurs surfaces de conduction (ici deux ou trois surfaces correspondant respectivement aux deux surfaces latérales et la surface du dessus). Les orientations des différents éléments formant le transistor seront faites au regard d'un repère orthogonale Oxyz.

Comme précédemment, le transistor à effet tunnel 600 est ici un transistor de type N comportant une architecture de diode PiN. Par souci de clarté la structure de grille n'est pas représentée en figure 13 et sera illustrée en référence à la figure 14 (qui représente de manière très schématique la structure de grille autour du canal) ; seuls les éléments essentiels à la compréhension de l'invention sont représentés ici, certains éléments tels par exemple les espaceurs ayant été volontairement omis pour rendre la figure 13 plus claire.

Ici, la région d'extension de source 602, la région de canal 601 et la région d'extension de drain 603 présentent chacune une certaine épaisseur de sorte qu'elles peuvent être qualifiées de tridimensionnelles.
Le canal 601 est réalisé dans un matériau semiconducteur (par exemple du silicium) intrinsèque ; ce canal 601 inclut deux parties d'épaisseurs différentes (suivant les deux directions Ox et Oz) ;
- une première partie 612 d'épaisseur ts1 suivant Oz et d'épaisseur ts1' suivant Ox ;
- et une deuxième partie 613 d'épaisseur ts1 +ti suivant Oz (donc strictement supérieure à ts1) et d'épaisseur ts1'+ti suivant Ox (dont strictement supérieur à ts1').
La structure de grille (cf. référence 606 de la figure 14) non représentée en figure 13 va recouvrir la première partie 612 du canal sur ses deux surfaces latérales (surface SL visible sur les figures 13 et 14 et la surface en vis-à-vis non visible) parallèles au plan Oyz et sur sa surface supérieure SP parallèle au plan Oxy. Le contact se fait donc par les deux côtés (cf. flèche 701) et par le dessus (flèche 702), donc sur trois surfaces au lieu d'une. On notera que, selon la technologie Fin-TFET, seules les surfaces latérales sont utilisées alors la technologie Trigate utilise les trois surfaces. On notera également qu'il ne s'agit pas de trois grilles différentes mais d'une structure de grille à trois surfaces de contact. Selon ce mode de réalisation, on comprend aisément que le canal de conduction est compris aussi bien dans les deux plans SL que dans le plan SP, les porteurs suivant aussi bien les flèches 701 que 702.
La région d'extension de source 602 prolonge, selon la direction du mouvement des porteurs (ici Oy), la première partie 612 du canal 601 et est réalisée dans un matériau semiconducteur fortement dopé P de type P+ (par exemple du Si dopé B) ; la région d'extension de source 602 présente une épaisseur ts1 sensiblement égale à l'épaisseur de la première partie 612 suivant la direction Oz et une épaisseur ts1' sensiblement égale à l'épaisseur de la première partie 612 suivant la direction Ox.
La région d'extension de drain 603 recouvre la deuxième partie 613 du canal sur ses deux surfaces latérales parallèles au plan Oyz et sur sa surface supérieure parallèle au plan Oxy. La région d'extension de drain est réalisée dans un matériau semiconducteur fortement dopé N de type N+ (par exemple du Si dopé P).
Selon l'invention, le transistor 600 comporte une zone de barrière 620 insérée, sur une épaisseur ts3, entre la deuxième partie 613 et la région d'extension de drain 603, ladite zone de barrière 620 étant réalisée dans un matériau semiconducteur fortement dopé P de type P+ (par exemple du Si dopé B).

Selon ce troisième mode de réalisation, la zone de barrière P+ 620 est donc insérée sur une épaisseur ts3 selon les directions Oz et Ox perpendiculaires aux plans de conduction SP et SL contenant le canal. L'invention trouve une application particulièrement intéressante dans le cas des applications de faible puissance ou l'électronique basse tension, par exemple dans le cas de la réalisation de mémoire statique SRAM (« Static Random Access Memory » en langue anglaise).

Bien entendu, le transistor selon l'invention n'est pas limité aux modes de réalisation qui viennent d'être décrits à titre indicatif et nullement limitatif en référence aux figures.

Ainsi, même si l'invention a été plus particulièrement décrite dans le cas d'un transistor à effet tunnel de type N, il est entendu qu'elle s'applique tout autant à un transistor à effet tunnel de type P en inversant le dopage P et N des régions semi-conductrices d'extension de source, de drain et de la zone de barrière.

En outre, même si les différentes courbes présentées ont été obtenues pour des transistors à double grille, il est entendu que des résultats semblables sont obtenus pour un transistor selon l'invention à simple grille tel que celui représenté en figure 12f. Un transistor TFET à double grille comporte en effet les mêmes éléments que ceux d'un transistor à effet tunnel à simple grille sur sa partie supérieure avec en plus une partie inférieure (intégrant notamment la grille de commande inférieure) totalement symétrique de la partie supérieure du transistor par rapport au plan du substrat. Dans tous les cas, selon l'invention, une zone dopée selon un dopage inverse du dopage de la région d'extension de drain est insérée entre le canal et la région d'extension de drain.

L'invention s'applique à tout type de structure de transistor à effet tunnel, les modes de réalisation décrits plus haut étant donnés à titre purement illustratif..

De même, l'invention s'applique quel que soit le type de substrat utilisé (substrat du type semiconducteur sur isolant ou SOI (« Silicon On Insulator ») ou substrat de type bulk par exemple).

## Revendications

1. Transistor (100, 200, 200', 600) à effet tunnel comportant :
- un canal (101, 201, 601) réalisé dans un matériau semi-conducteur intrinsèque ;
- des régions d'extension de source (102, 202, 202', 602) et de drain (103, 203, 603) de part et d'autre dudit canal (101, 201, 601), ladite région d'extension de source (102, 202, 202', 602) étant réalisée dans un matériau semi-conducteur dopé selon un premier type de dopage P ou N et ladite région d'extension de drain (103, 203A, 603) étant réalisée dans un matériau semi-conducteur dopé selon un second type de dopage inverse dudit premier type de dopage, ladite région d'extension de source servant à injecter par effet tunnel des porteurs de charge dans le canal ;
- des régions conductrices de source (104, 204) et de drain (105, 205) respectivement en contact avec les régions d'extension de source (102, 202) et de drain (103, 203A) ;
- une structure de grille (106, 206, 606) comportant :
○ une couche diélectrique (108, 208) de grille en contact avec ledit canal ;
○ une zone de grille (107, 207) agencée de sorte que ladite couche diélectrique de grille est disposée entre ladite zone de grille et ledit canal ;
ledit transistor étant **caractérisé en ce qu'**il comporte une zone dopée selon le premier type de dopage (120, 220A, 620) insérée entre le canal (101, 201, 613) et la région d'extension de drain (103, 203A, 603), ladite zone dopée formant barrière, empêchant les porteurs de charges de s'échapper de ladite région d'extension de drain.

2. Transistor (100, 200, 200', 600) selon la revendication précédente **caractérisé en ce que** la concentration de dopants de ladite zone dopée selon le premier type de dopage est comprise entre 10¹⁹ cm⁻³ et 5.10¹⁹ cm⁻³.

3. Transistor (100, 200, 200', 600) selon la revendication précédente **caractérisé en ce que** la concentration de dopants de ladite zone dopée selon le premier type de dopage est sensiblement égale à 3.10¹⁹ cm⁻³.

4. Transistor (100) selon l'une des revendications précédentes **caractérisé en ce que** ladite zone dopée (120) selon le premier type de dopage est insérée sur une longueur (Lb) mesurée selon la direction longitudinale du canal (101) et comprise entre 5 et 20 nm.

5. Transistor (200, 200', 600) selon l'une des revendications 1 à 3 **caractérisé en ce que** ladite zone dopée (220A, 620) selon le premier type de dopage est insérée sur une épaisseur mesurée perpendiculairement à au moins un plan de conduction dudit canal (201, 601) et comprise entre 8 et 20 nm.

6. Transistor (200, 200') selon la revendication 5 **caractérisé en ce qu'**il comporte un espaceur isolant la région conductrice de drain et la zone de grille, ledit espaceur présentant une épaisseur (LSP) mesurée parallèlement à la direction longitudinale du canal (201) et comprise entre 5 nm et 10 nm.

7. Transistor (200, 200') selon l'une des revendications 5 et 6 **caractérisé en ce que** ledit canal (201) comporte :
- une première partie (212) orientée selon la direction longitudinale du canal et présentant une épaisseur (ts1) donnée ; et
- au moins une dérivation (213A) s'étendant suivant une direction perpendiculaire à au moins un plan de conduction du canal et présentant une épaisseur strictement supérieure à l'épaisseur (ts1) de la première partie, ladite zone dopée (220A) selon le premier type de dopage étant dans le prolongement de ladite dérivation.

8. Transistor (600) selon la revendication 5 **caractérisé en ce que** ledit canal (601) présente au moins deux plans de conduction (SL, SP), ladite zone dopée (620) selon le premier type de dopage étant insérée sur une épaisseur mesurée perpendiculairement à chacun desdits plans de conduction dudit canal.
